# EUROPÄISCHE PATENTANMELDUNG

(11) **EP 4 778 374 A1**
(43) Veröffentlichungstag der Anmeldung: **22.07.2026**
(21) Anmeldenummer: 25216816.6
(22) Anmeldetag: 19.11.2025
(51) Int. Cl.: A01B 76/00, G05B 23/02, G06Q 10/20

(54) **COMPUTER-IMPLEMENTIERTES VERFAHREN ZUM REPARIEREN EINER LANDWIRTSCHAFTLICHEN ARBEITSMASCHINE**

(30) Priorität: 15.01.2025 DE 102025101263
(71) Anmelder: CLAAS E-Systems GmbH, 49201 Dissen (DE)
(72) Erfinder: Jathe, Benjamin, 33803 Steinhagen (DE); Itzek, Ralf, 48361 Beelen (DE); Hesse, Reinhard, 33775 Versmold (DE); Grunwald, Jörn, 33428 Marienfeld (DE); Pellengahr, Martin, 48167 Münster (DE); Niewöhner, Stephan, 48147 Münster (DE); Rüter, Sebastian, 33428 Harsewinkel (DE)
(74) Vertreter: CLAAS Gruppe

(57) **Zusammenfassung**

Die vorliegende Erfindung betrifft ein computer-implementiertes Verfahren (100) zum Reparieren einer landwirtschaftlichen Arbeitsmaschine (200), wobei die landwirtschaftliche Arbeitsmaschine (200) ein zu wartendes Bauteil (205) umfasst, das Verfahren (100) umfassend: Bereitstellen (S1.1) eines computergestützten Modells, wobei das computergestützte Modell dem zu wartenden Bauteil (205) zugeordnet ist; Erfassen (S1.2) eines Istzustands des zu wartenden Bauteils (205) und anpassen (S1.3) des computergestützten Modells an den erfassten Istzustand des zu wartenden Bauteils (205); Bestimmen (S1.4) von Reparaturszenarien (R1, R2, R3) der landwirtschaftlichen Arbeitsmaschine (200) basierend auf dem computergestützten Modell; und Ermitteln (S1.5) einer Reparaturmaßnahme (M) mittels der Reparaturszenarien (R1, R2, R3).

## Beschreibung

Die vorliegende Erfindung betrifft ein computer-implementiertes Verfahren zum Reparieren einer landwirtschaftlichen Arbeitsmaschine. Ferner betrifft die vorliegende Erfindung ein Verfahren zur Durchführung einer geführten Reparatur eines zu wartenden Bauteils basierend auf einer ermittelten Reparaturmaßnahme. Die vorliegende Erfindung betrifft auch ein System zur Datenverarbeitung für Reparaturen einer landwirtschaftlichen Arbeitsmaschine und einen landwirtschaftlichen Reparaturassistent.

Aus dem Stand der Technik sind Verfahren zum Reparieren einer landwirtschaftlichen Arbeitsmaschine bekannt.

Die EP 3738421 B1 schlägt hierfür ein Verfahren vor, bei dem in einer Analyseroutine auf Basis von Betriebsdaten der landwirtschaftlichen Arbeitsmaschine eine Ausfalldauerwahrscheinlichkeit oder eine Beschädigungswahrscheinlichkeit der landwirtschaftlichen Arbeitsmaschine oder eines Bauteils der landwirtschaftlichen Arbeitsmaschine ermittelt wird. Auf Basis der Analyseroutine kann eine Lieferroutine initiiert werden.

Nach Lieferung des Ersatzteils ist es in der Regel notwendig, im Servicepunkt Reparaturmaßnahmen einzuleiten. Angesichts der zunehmenden Anzahl und Komplexität der Bauteile sowie der für die Reparatur erforderlichen Werkzeuge werden diese Arbeiten immer anspruchsvoller. Daher besteht ein Bedarf an verbesserten Verfahren, die kostengünstiger, effizienter und kompakter sind.

Die vorliegende Erfindung hat sich zum Ziel gesetzt, ein Verfahren zur Reparatur von landwirtschaftlichen Arbeitsmaschinen zu entwickeln, das eine schnelle und zuverlässige Instandsetzung ermöglicht.

Diese Aufgabe wird durch die hier offenbarten Ausführungsformen gelöst, die insbesondere durch den Gegenstand der unabhängigen Ansprüche definiert sind. Die abhängigen Ansprüche betreffen weitere Ausführungsformen. Verschiedene Aspekte und Ausführungsformen dieser Aspekte sind auch in der nachstehenden Zusammenfassung und Beschreibung offenbart, die zusätzliche Merkmale und Vorteile bieten.

Ein Aspekt bezieht sich auf ein computer-implementiertes Verfahren zum Reparieren einer landwirtschaftlichen Arbeitsmaschine. Dabei kann die landwirtschaftliche Arbeitsmaschine ein zu wartendes Bauteil umfassen. Das Verfahren kann in einem Schritt ein Bereitstellen eines computergestützten Modells umfassen, wobei das computergestützte Modell dem zu wartenden Bauteil zugeordnet sein kann. Das Verfahren kann in einem weiteren Schritt ein Erfassen eines Istzustands des zu wartenden Bauteils umfassen. Ferner kann das Verfahren ein Anpassen des computergestützten Modells an den erfassten Istzustand des zu wartenden Bauteils umfassen. Des Weiteren kann das Verfahren in einem weiteren Schritt ein Bestimmen von Reparaturszenarien der landwirtschaftlichen Arbeitsmaschine basierend auf dem computergestützten Modell umfassen. Das Verfahren kann in einem weiteren Schritt ein Ermitteln einer Reparaturmaßnahme mittels der Reparaturszenarien umfassen.

Die landwirtschaftliche Arbeitsmaschine kann speziell für die Ernte von Nutzpflanzen vorgesehen sein. Bei der landwirtschaftlichen Arbeitsmaschine kann es sich beispielsweise um einen Feldhäcksler, Mähdrescher oder Traktor handeln. Die landwirtschaftliche Arbeitsmaschine kann selbstfahrend und/oder autonom ausgeprägt sein. Das Reparieren der landwirtschaftlichen Arbeitsmaschine kann den Prozess bezeichnen, bei dem die landwirtschaftliche Arbeitsmaschine, die defekt oder nicht optimal funktionsfähig ist, zumindest teilweise wieder in einen betriebsbereiten und effizienten Zustand versetzt wird.

Das zu wartende Bauteil kann sich auf ein spezifisches Element oder eine Komponente der landwirtschaftlichen Arbeitsmaschine beziehen, das (regelmäßig) Inspektion, Pflege oder Reparatur (d.h. Wartung) benötigt, um seine Funktionstüchtigkeit und Leistungsfähigkeit zu erhalten. In einem landwirtschaftlichen Kontext könnte dies beispielsweise ein Teil eines Traktors oder einer Erntemaschine sein, das aufgrund von Verschleiß, Alterung oder Beschädigung Aufmerksamkeit erfordert. Für das vorliegende Verfahren kann es bereits bekannt sein, welches Bauteil zu warten ist. Das heißt, es muss nicht identifiziert werden, sondern es kann bereits vor dem Verfahren festgelegt worden oder allgemein bekannt sein, welches Bauteil zu warten ist.

Das Bereitstellen des computergestützten Modells kann sich auf den Prozess beziehen, bei dem ein digitales Abbild oder eine Simulation eines physischen Objekts, Systems oder Prozesses erstellt und zugänglich gemacht wird. Das computergestützte Modell wird mithilfe von Computertechnologie entwickelt und kann die Eigenschaften, Funktionen und das Verhalten des realen Gegenstands nachbilden. In der Praxis ermöglicht ein computergestütztes Modell die Analyse, Planung und Optimierung von Prozessen oder Strukturen ohne direkte Eingriffe in das physische Original. Verschiedene mathematische Modelle für computergestützte Modelle umfassen Differentialgleichungen, lineare und nichtlineare Optimierungsmodelle, stochastische Modelle, neuronale Netze und/oder agentenbasierte Modelle.

Die Reparaturszenarien können sich auf theoretische Planungsabläufe der Reparatur beziehen, d.h. konzeptionelle Strategien und Schritte, die im Vorfeld einer tatsächlichen Reparatur entwickelt werden, um die Reparatur effizient und effektiv durchzuführen. Diese Szenarien berücksichtigen möglicherweise verschiedene mögliche Probleme (bspw. äußere Einflüsse wie mechanische Kräfte) und deren Lösungen, basierend auf den vorhandenen Informationen über das Bauteil und die Maschine.

Die Zuordnung eines computergestützten Modells zu einem zu wartenden Bauteil kann durch eine Vielzahl von Technologien und Methoden erfolgen, die die Effizienz und Präzision in der Wartungsarbeit erheblich verbessern. Ein gängiger Ansatz ist der Einsatz von Barcode- oder RFID-Scanning, bei dem jedes Bauteil mit einem eindeutigen Code versehen wird, der beim Scannen das entsprechende digitale Modell im System aufruft. Alternativ können eindeutige Seriennummern verwendet werden, die in einer Datenbank gespeichert sind und als Schlüssel dienen, um das passende Modell zu identifizieren. Mit der fortschreitenden Technologie können auch Sensoren und loT-Geräte eingesetzt werden, die kontinuierlich Daten von den Bauteilen sammeln und so helfen, das richtige Modell im System zu finden. Ein weiterer innovativer Ansatz ist beispielsweise die Bilderkennung, bei der Kameras und spezialisierte Software das Bauteil automatisch erkennen und das passende digitale Abbild zuordnen können. In Fällen, in denen automatisierte Systeme nicht zur Verfügung stehen, können Techniker die Identifikationsdaten manuell eingeben, um die Verbindung herzustellen. Schließlich bieten integrierte Softwarelösungen umfassende Datenbanken, die auf Basis spezifischer Parameter wie Größe, Form oder Funktion automatisch das richtige Modell auswählen können.

Der Istzustand eines zu wartenden Bauteils kann den aktuellen Zustand oder die gegenwärtige Beschaffenheit des Bauteils zu einem bestimmten Zeitpunkt beschreiben. Dieser Zustand kann alle relevanten Merkmale und Eigenschaften des Bauteils umfassen, die für die Beurteilung seiner Funktionsfähigkeit und den Wartungsbedarf von Bedeutung sind. Dazu können beispielsweise physische Abnutzung, Verschleiß, Beschädigungen, Materialermüdung und technische Parameter wie Temperatur, Druck oder Vibrationen, die durch den Betrieb des Bauteils beeinflusst werden, gehören.

Beim Anpassen des computergestützten Modells an den erfassten Istzustand können geometrische Anpassungen vorgenommen werden, wenn bei der Inspektion bzw. Diagnose festgestellt wird, dass ein Bauteil verformt oder abgenutzt ist. Das computergestützte (digitale) Modell kann entsprechend modifiziert werden, um diese Veränderungen widerzuspiegeln. Ebenso können Materialeigenschaften aktualisiert werden, wenn Alterung oder Umwelteinflüsse die Festigkeit oder Elastizität des Materials verändert haben. Auch Oberflächeneigenschaften wie raue oder korrodierte Stellen können im Modell dargestellt werden, um Reibungs- oder Verschleißsimulationen zu erleichtern. Strukturelle Defekte wie Risse können im Modell eingefügt werden, um die Integrität des Bauteils zu analysieren und Reparaturszenarien zu bestimmen. Darüber hinaus können funktionale Parameter wie Temperatur, Druck oder Vibration, die das Bauteil unter realen Betriebsbedingungen erfährt, angepasst werden, um zukünftige Probleme vorherzusagen. Ferner können Veränderungen an Verbindungsstellen, wie Spiel oder Lockerungen, im Modell dargestellt werden, um Montagestrategien (d.h. Reparaturszenarien) zu optimieren. Durch diese Anpassungen kann das computergestützte Modell möglicherweise zu einem präzisen virtuellen Abbild des Istzustands des physischen Bauteils werden, was die Grundlage für den Reparaturprozess bilden kann.

Die Reparaturmaßnahmen können sich auf tatsächliche physikalische Tätigkeiten beziehen, d.h. konkrete, praktische Schritte, die unternommen werden, um ein defektes oder abgenutztes Bauteil der landwirtschaftlichen Arbeitsmaschine wieder in einen funktionsfähigen Zustand zu versetzen. Dazu zählen beispielsweise Demontagen, Reinigungen und/oder Reparaturen von Defekten. Bei einer Reparaturmaßnahme kann es sich um das zumindest teilweise Umsetzen bzw. praktische Anwenden der (theoretischen) Reparaturszenarien handeln. Reparaturmaßnahmen können als Instandsetzung bzw. Instandsetzungsmaßnahmen verstanden werden.

Ein Vorteil des Verfahrens kann es sein, dass die Leistungsfähigkeit und Lebensdauer der landwirtschaftlichen Arbeitsmaschine erhalten oder verbessert wird, um einen reibungslosen landwirtschaftlichen Betrieb zu gewährleisten. Es ist ferner möglich, kostengünstig und recheneffizient eine Vielzahl von Reparaturszenarien mittels Computersystemen (bspw. Cloudsystemen) zu bestimmen, um aus den Reparaturszenarien eine passende Reparaturmaßnahme abzuleiten. Es kann somit für das zu wartende Bauteil eine individuell angepasste Reparaturmaßnahme (bzw. Instandsetzung) ermittelt werden. Die Wartung der zu wartenden Bauteile kann entscheidend sein, um Ausfälle zu vermeiden und die Effizienz und Sicherheit der gesamten Arbeitsmaschine zu gewährleisten. Ein weiterer Vorteil ist das Minimieren der Reparaturzeit der landwirtschaftlichen Arbeitsmaschine.

In einem weiteren Aspekt kann der Istzustand des zu wartenden Bauteils erfasst werden, indem eine geführte Diagnose durchgeführt wird. Die geführte Diagnose kann in einem Schritt ein Erfassen einer Bedienereingabe zur Beschreibung der Mängel der landwirtschaftlichen Arbeitsmaschine oder des zu wartenden Bauteils umfassen. Des Weiteren kann die geführte Diagnose in einem weiteren Schritt ein Navigieren durch einen interaktiven Entscheidungsbaum basierend auf den Bedienereingaben und dem dem zu wartenden Bauteil zugeordneten computergestützten Modell umfassen. Dabei können optional spezifische Tests oder Inspektionen zur weiteren Fehlerdiagnose vorgeschlagen werden. In einem weiteren Schritt kann die geführte Diagnose das Erfassen des Istzustands des zu wartenden Bauteils umfassen. Der Istzustand kann dabei erfasst werden, indem die Testergebnisse zusammengefasst werden.

Die geführte Diagnose kann ein strukturierter Prozess zur Mängelsuche und -behebung sein, bei dem Techniker oder Benutzer durch eine Reihe von vorgegebenen Schritten oder Fragen geleitet werden, um systematisch die Ursache eines Problems bzw. Defekt am zu wartenden Bauteil zu identifizieren. Üblicherweise kommen bei der geführten Diagnose Software oder Anleitungen zum Einsatz, um den Diagnoseprozess zu standardisieren und effizienter zu gestalten.

Der interaktive Entscheidungsbaum kann ein visuelles und/oder strukturiertes Hilfsmittel sein, das zur Entscheidungsfindung verwendet wird, indem es verschiedene Optionen und deren mögliche Konsequenzen darstellt. Der interaktive Entscheidungsbaum ermöglicht Bedienern beispielsweise, durch eine Reihe von Fragen oder Entscheidungen zu navigieren, wobei jede Auswahl zu einem spezifischen Pfad führt, der weitere Schritte oder Empfehlungen basierend auf den getroffenen Entscheidungen aufzeigt. Interaktiv bedeutet möglicherweise eine wechselseitige Kommunikation oder Aktion zwischen Bediener und System (bspw. einem Reparaturassistenten), bei der beide Parteien aufeinander reagieren und beeinflussen können. Verschiedene mathematische Modelle für Entscheidungsbäume umfassen beispielsweise den CART-Algorithmus (Classification and Regression Trees), den ID3-Algorithmus (Iterative Dichotomiser 3), den C4.5-Algorithmus und den Random Forest-Ansatz.

Ein Vorteil der geführten Diagnose kann es sein, dass der Istzustand des zu wartenden Bauteils besonders präzise bestimmt werden kann. Die geführte Diagnose kann dazu beitragen, Zeit zu sparen, Fehler zu minimieren und für Konsistenz im Diagnoseprozess zu sorgen. Auch weniger erfahrene Anwender können effektiv arbeiten, da sie möglicherweise durch einen (standardisierten) Prozess geleitet werden. Die geführte Diagnose kann zur Optimierung von Wartungsstrategien beitragen und zu Kosteneinsparungen führen, indem unnötige Reparaturen vermieden werden. Insgesamt kann die geführte Diagnose die Zuverlässigkeit und Verfügbarkeit von Maschinen erhöhen.

In einem weiteren Aspekt kann ein simuliertes Reparaturszenarium der landwirtschaftlichen Arbeitsmaschine bestimmt werden, indem verschiedene Maßnahmen mittels der computergestützten Modelle simuliert werden. Dabei kann das Simulieren in einem Schritt ein Erstellen eines virtuellen Szenariums im computergestützten Modell umfassen. Das virtuelle Szenarium kann die aktuelle Konfiguration der landwirtschaftlichen Arbeitsmaschine widerspiegeln. Das Simulieren kann in einem weiteren Schritt ein Ermitteln von Simulationsergebnissen umfassen. Die Simulationsergebnisse können erfasst werden, indem ein Reparaturszenarium implementiert wird und Belastungs- und Funktionsanalysen innerhalb des virtuellen Szenariums durchgeführt werden. In einem weiteren Schritt kann das Simulieren ein Generieren eines Berichts über die Simulationsergebnisse umfassen. Der Bericht kann detaillierte Informationen zu den durchgeführten Analysen, den erwarteten Leistungsverbesserungen und potenziellen Risiken des Reparaturszenariums enthalten.

Die aktuelle Konfiguration der landwirtschaftlichen Arbeitsmaschine kann beispielsweise die spezifische Ausstattung, Einstellungen und Software umfassen, die zu einem bestimmten Zeitpunkt an der Maschine vorhanden sind, einschließlich Anbaugeräten, technischen Einstellungen und elektronischen Systemen.

Die Simulation bzw. das Simulieren kann es ermöglichen, potenzielle Reparaturmaßnahmen virtuell zu testen, bevor physische Eingriffe erfolgen, was das Risiko von Fehlentscheidungen und kostspieligen Fehlern reduziert. Die Qualität der Wartung könnte somit gesteigert werden.

In einem weiteren Aspekt kann das Verfahren ein Veranlassen der Reparaturmaßnahme an der landwirtschaftlichen Arbeitsmaschine umfassen. Dabei kann die Reparaturmaßnahme insbesondere den Austausch des zu wartenden Bauteils gegen ein baugleiches Neuteil, ein bauähnliches Bauteil, ein generalüberholtes Bauteil oder ein aktualisiertes Bauteil umfassen.

Das Veranlassen der Reparaturmaßnahme kann automatisiert erfolgen und kann dabei die Flexibilität erhöhen. Es ist möglich, dass als Reparaturmaßnahme die passendste und kosteneffizienteste Lösung gewählt wird, je nach Verfügbarkeit und Budget. Dieser Ansatz kann eine schnelle Wiederherstellung der Betriebsbereitschaft der landwirtschaftlichen Maschine erhöhen, da die Reparaturmaßnahmen klar definiert und im Voraus geplant sind.

In einem weiteren Aspekt können die Reparaturszenarien mittels des computergestützten Modells bestimmt werden, indem eine Vielzahl von Reparaturschritten festgelegt wird, verschiedene Reihenfolgen für die Reparaturschritte ermittelt werden und jedem Reparaturszenarium eine Reihenfolge der Reparaturschritte zugeordnet wird.

Ein Reparaturschritt kann sich auf eine spezifische, definierte Aktion oder Maßnahme beziehen, die im Rahmen einer Reparatur durchgeführt wird. Ein Reparaturschritt kann beispielsweise die Montage, Demontage oder Reinigung eines spezifischen Bauteils der landwirtschaftlichen Arbeitsmaschine sein.

In einem weiteren Aspekt kann die Ermittlung der Reparaturmaßnahme durch eine Priorisierung der Reparaturszenarien erfolgen. Dabei kann die Priorisierung auf der Grundlage der Kosten, der Zeit und/oder dem Energieaufwand ermittelt werden.

Das Priorisieren kann den Prozess des Anordnens oder Bewertens von Aufgaben bezeichnen, Projekten oder Zielen nach ihrer Wichtigkeit oder Dringlichkeit, um Ressourcen und Zeit effektiv zu nutzen. Das Ziel der Priorisierung kann es beispielsweise sein, sicherzustellen, dass die wichtigsten oder dringlichsten Aufgaben zuerst bearbeitet werden, um den größten Nutzen oder die effektivsten Ergebnisse zu erzielen. Methoden zur Priorisierung können einfache To-Do-Listen bis hin zu komplexeren Techniken wie der Eisenhower-Matrix oder der MoSCoW-Methode umfassen, die helfen können, Aufgaben zu kategorisieren und zu bewerten. Mittels des Priorisierens kann das Verfahren zeiteffizienter gestaltet werden.

In einem weiteren Aspekt kann das computergestützte Modell ein dreidimensionales Modell des zu wartenden Bauteils umfassen. Das computergestützte Modell kann eine geometrische Struktur und/oder Materialeigenschaften abbilden, wobei die geometrische Struktur optional von dem erfassten Istzustand des zu wartenden Bauteils abgeleitet wird.

Die geometrische Struktur eines zu wartenden Bauteils kann sich auf die physische Form, das Design und die räumliche Anordnung seiner Bestandteile beziehen. Dazu können spezifische Maße wie Länge, Breite, Höhe, Durchmesser, Winkel und andere geometrische Merkmale beziehen, die die Form und das Volumen des Bauteils definieren. Die Materialeigenschaften können die physikalischen und chemischen Eigenschaften des Materials beschreiben, aus dem das Bauteil besteht. Dazu können beispielsweise Festigkeit, Härte, Wärmebeständigkeit oder Elastizität gehören.

In einem weiteren Aspekt kann das Bereitstellen des computergestützten Modells in einem Schritt ein Bereitstellen eines allgemeinen Modells für das zu wartende Bauteil umfassen. In einem weiteren Schritt kann das Bereitstellen des computergestützten Modells ein Erfassen von Informationen über das zu wartende Bauteil umfassen. Dabei kann die Informationen optional historische Daten früherer Wartungen und Reparaturen des zu wartenden Bauteils umfassen. In einem weiteren Schritt kann das Bereitstellen des computergestützten Modells ein Anpassen des allgemeinen Modells basierend auf Informationen über das zu wartende Bauteil umfassen. Dabei kann das allgemeine Modell angepasst werden, so dass das computergestützte Modell abgeleitet wird.

In einem weiteren Aspekt kann das Ermitteln der Reparaturmaßnahme in einem Schritt eine Analyse der Reparaturszenarien umfassen. Die Reparaturszenarien können analysiert werden, indem verschiedene Reparaturszenarien basierend auf dem Istzustand des zu wartenden Bauteils und/oder den verfügbaren Ressourcen identifiziert und bewertet werden. In einem weiteren Schritt kann das Ermitteln der Reparaturmaßnahme ein Auswählen eines optimalen Reparaturszenariums umfassen, indem Kosten, Zeit und Energieaufwand der Maßnahmen gegeneinander abgewogen werden. In einem weiteren Schritt kann das Ermitteln der Reparaturmaßnahme ein Ermitteln von Reparaturmaßnahmen aus dem optimalen Reparaturszenarium umfassen, indem Reparaturschritte aus dem optimalen Reparaturszenarium abgeleitet werden.

Ein weiterer Aspekt bezieht sich auf ein Verfahren zur Durchführung einer geführten Reparatur eines zu wartenden Bauteils basierend auf einer ermittelten Reparaturmaßnahme nach einem der vorhergehenden Aspekte. Das Verfahren kann in einem Schritt ein Bereitstellen einer detaillierten Anleitung zur Reparaturmaßnahme, die spezifische Schritte und erforderliche Werkzeuge beschreibt, umfassen. In einem weiteren Schritt kann das Verfahren ein Bereitstellen eines landwirtschaftlichen Reparaturassistenten, der den Bediener in Echtzeit durch den Reparaturprozess führt, indem er visuelle und akustische Hinweise gibt, umfassen. In einem weiteren Schritt kann das Verfahren ein Überwachen des Reparaturfortschritts mittels Sensoren und/oder Feedback-Systemen umfassen.

Ein weiterer Aspekt bezieht sich auf ein System zur Datenverarbeitung für Reparaturen einer landwirtschaftlichen Arbeitsmaschine, umfassend einen Prozessor, der so angepasst und/oder konfiguriert ist, dass er das Verfahren nach einem der vorhergehenden Aspekte ausführt.

Ein weiterer Aspekt bezieht sich auf einen landwirtschaftlichen Reparaturassistent mit einem System zur Datenverarbeitung nach einem der vorhergehenden Aspekte.

Der Reparaturassistent unterstützt vorteilhafterweise einen Bediener bzw. Techniker bei der Wartung der landwirtschaftlichen Arbeitsmaschine. Der landwirtschaftliche Reparaturassistent kann den Reparaturprozess automatisiert durchführen und kann dabei helfen die landwirtschaftliche Arbeitsmaschine effizienter und genauer zu reparieren. Es ist möglich, dass der Reparaturassistent mobil installierbar ist. Dies kann zu einer verbesserten Wartungseffizienz, verringerten Ausfallzeiten und optimaler Nutzung der landwirtschaftlichen Arbeitsmaschine führen.

Es versteht sich, dass die vorstehend genannten und die nachstehend noch zu erläuternden Merkmale nicht nur in der jeweils angegebenen Kombination, sondern auch in anderen Kombinationen oder in Alleinstellung verwendbar sind, ohne den Rahmen der vorliegenden Erfindung zu verlassen.

Für den Fachmann ist ersichtlich, dass die vorgestellten Verfahren in Form von Anweisungen in Software oder auf einem Computerprogrammprodukt implementiert oder gespeichert sein können, wobei gespeicherte Anweisungen es ermöglichen, die Schritte nach dem Verfahren auszuführen, wenn eine entsprechende datenverarbeitende Maschine durch die Software gesteuert wird. Mit anderen Worten ist es möglich, dass es sich bei den Verfahren um computer-implementierte Verfahren handelt. Ausführungsformen beziehen sich daher auch auf ein Speichermedium mit darauf gespeicherter Software, die ausgebildet ist, um die vorgestellten Verfahren durchzuführen, wenn die Software auf einer datenverarbeitenden Einrichtung ausgeführt wird.

Weitere Vorteile und Merkmale ergeben sich aus den folgenden Ausführungsformen, die sich zum Teil auf die Figuren beziehen. Die Figuren zeigen die Ausführungsformen nicht immer maßstabsgetreu. Die Abmessungen der verschiedenen Merkmale können insbesondere zur Klarheit der Beschreibung entsprechend vergrößert oder verkleinert sein. Hierzu sind die Figuren zumindest teilweise schematisiert.

Es zeigt:
- Fig. 1: eine schematische Darstellung eines computer-implementierten Verfahrens zum Reparieren einer landwirtschaftlichen Arbeitsmaschine gemäß einer Ausführungsform; und
- Fig. 2: eine schematische Darstellung eines Reparaturassistenten mit einem System zur Datenverarbeitung für Reparaturen einer landwirtschaftlichen Arbeitsmaschine gemäß einer Ausführungsform.

In der folgenden Beschreibung wird auf die beigefügten Figuren verwiesen, die Teil der Offenbarung sind und bestimmte Aspekte und Ausführungsformen veranschaulichen, unter denen die vorliegende Offenbarung verstanden werden kann. Gleiche Bezugszeichen beziehen sich auf gleiche oder zumindest funktionell oder strukturell ähnliche Merkmale.

Im Allgemeinen gilt eine Offenbarung eines beschriebenen Verfahrens auch für eine entsprechende Vorrichtung zur Durchführung des Verfahrens oder ein entsprechendes System, das ein oder mehrere Vorrichtungen umfasst, und umgekehrt. Wird beispielsweise ein bestimmter Verfahrensschritt beschrieben, so kann eine entsprechende Vorrichtung ein Merkmal zur Durchführung des beschriebenen Verfahrensschrittes enthalten, auch wenn dieses Merkmal in der Abbildung nicht ausdrücklich beschrieben oder dargestellt ist. Wird dagegen beispielsweise ein bestimmtes Gerät auf der Grundlage von Funktionseinheiten beschrieben, kann ein entsprechendes Verfahren einen oder mehrere Schritte zur Durchführung der beschriebenen Funktionalität enthalten, auch wenn diese Schritte in den Abbildungen nicht explizit beschrieben oder dargestellt sind. Ähnlicherweise kann ein System entsprechende Vorrichtungsmerkmal oder Merkmale zur Durchführung eines bestimmten Verfahrensschritts umfassen. Die Merkmale der verschiedenen oben oder unten beschriebenen beispielhaften Aspekte und Ausführungsformen können kombiniert werden, sofern nicht ausdrücklich etwas anderes angegeben ist.

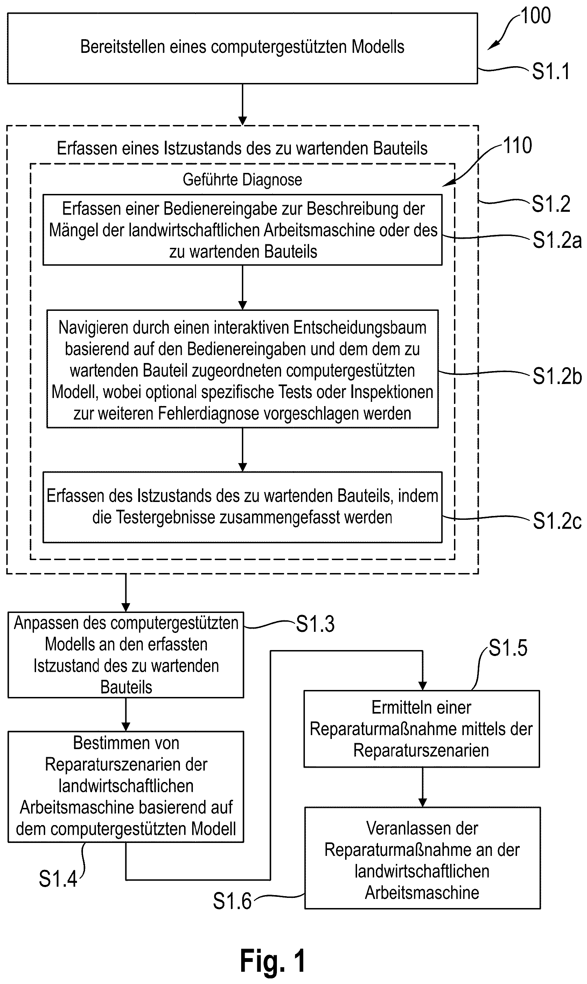

Fig. 1 zeigt eine schematische Darstellung eines computer-implementierten Verfahrens 100 zum Reparieren einer landwirtschaftlichen Arbeitsmaschine gemäß einer Ausführungsform.

Die hier nicht abgebildete landwirtschaftliche Arbeitsmaschine umfasst ein zu wartendes Bauteil, d.h. eine Komponente, die Inspektion, Pflege oder Reparatur (d.h. eine Instandsetzung) benötigt, damit die landwirtschaftliche Arbeitsmaschine funktions- und leistungsfähig ist.

Das Verfahren 100 umfasst in einem ersten Schritt S1.1 möglicherweise ein Bereitstellen eines computergestützten Modells. Das computergestützte Modell ist beispielsweise dem zu wartenden Bauteil zugeordnet.

In einem weiteren Schritt S1.2 umfasst das Verfahren 100 ein Erfassen eines Istzustands des zu wartenden Bauteils. Das Erfassen des Istzustands des zu wartenden Bauteils kann dabei weitere Unterschritte umfassen. Der Istzustand des zu wartenden Bauteils kann insbesondere erfasst werden, indem eine geführte Diagnose 110 durchgeführt wird.

Die geführte Diagnose 110 kann in einem Schritt S1.2a ein Erfassen einer Bedienereingabe zur Beschreibung der Mängel der landwirtschaftlichen Arbeitsmaschine oder des zu wartenden Bauteils umfassen. Die geführte Diagnose 110 kann in einem weiteren Schritt S1.2b ein Navigieren durch einen interaktiven Entscheidungsbaum basierend auf den Bedienereingaben und dem dem zu wartenden Bauteil zugeordneten computergestützten Modell umfassen. Dabei können optional spezifische Tests oder Inspektionen zur weiteren Fehlerdiagnose vorgeschlagen werden.

Beispielsweise kann einem Bediener bei der geführten Diagnose 110 die Anweisung gegeben werden, zu Beginn zu prüfen, ob das zu wartende Bauteil offensichtliche physische Schäden zeigt; falls ja, wird eine physische Inspektion empfohlen. Dafür können auch optische Verfahren zum Einsatz kommen, d.h. es kann ein Bild von dem zu wartenden Bauteil erfasst werden und physische Schäden mittels Computeralgorithmen detektiert werden. Wenn keine Schäden sichtbar sind, kann geprüft werden, ob das Bauteil nicht wie erwartet funktioniert. Bei Fehlfunktionen ohne physische Schäden wird weiter analysiert, ob das System Fehlermeldungen anzeigt, die dann entsprechend dem Fehlerbehebungsprotokoll behandelt werden. Sollten keine Fehlermeldungen vorliegen, wird beispielsweise untersucht, ob kürzlich Änderungen an der Software oder Hardware vorgenommen wurden, die gegebenenfalls rückgängig gemacht oder aktualisiert werden sollten. Wenn all diese Schritte keine Lösung bieten, wird möglicherweise vorgeschlagen, spezifische Tests durchzuführen, wie elektrische, mechanische oder sensorische Tests, um die Ursache der Fehlfunktion genauer zu bestimmen. Basierend auf den Ergebnissen dieser Tests können weitere Maßnahmen ergriffen oder ein Experte konsultiert werden. In einem weiteren Schritt S1.2c kann die geführte Diagnose 110 den Istzustand des zu wartenden Bauteils erfassen, indem die Testergebnisse zusammengefasst werden.

In einem weiteren Schritt S1.3 umfasst das Verfahren 100 ein Anpassen des computergestützten Modells an den erfassten Istzustand des zu wartenden Bauteils. Beispielsweise kann das zu wartende Bauteil Abnutzungen oder Risse aufweisen. Das computergestützte Modell kann derart angepasst werden, dass die Abnutzungen oder Risse im Modell mittels physikalischer, mathematischer Methoden abgebildet werden.

In einem weiteren Schritt S1.4 umfasst das Verfahren 100 ein Bestimmen von Reparaturszenarien der landwirtschaftlichen Arbeitsmaschine basierend auf dem computergestützten Modell. Dabei ist es möglich, kostengünstig und recheneffizient eine Vielzahl von Reparaturszenarien beispielsweise mittels eines Cloudsystems zu bestimmen, um aus den Reparaturszenarien eine passende Reparaturmaßnahme abzuleiten.

In einem weiteren Schritt S1.5 umfasst das Verfahren 100 ein Ermitteln einer Reparaturmaßnahme mittels der Reparaturszenarien. Es kann somit für das zu wartende Bauteil eine individuell angepasste Reparaturmaßnahme (bzw. Instandsetzung) ermittelt werden.

In einem weiteren Schritt S1.6 umfasst das Verfahren 100 ein Veranlassen der Reparaturmaßnahme an der landwirtschaftlichen Arbeitsmaschine. Dabei kann die Reparaturmaßnahme insbesondere den Austausch des zu wartenden Bauteils gegen ein baugleiches Neuteil, ein bauähnliches Bauteil, ein generalüberholtes Bauteil oder ein aktualisiertes Bauteil umfassen.

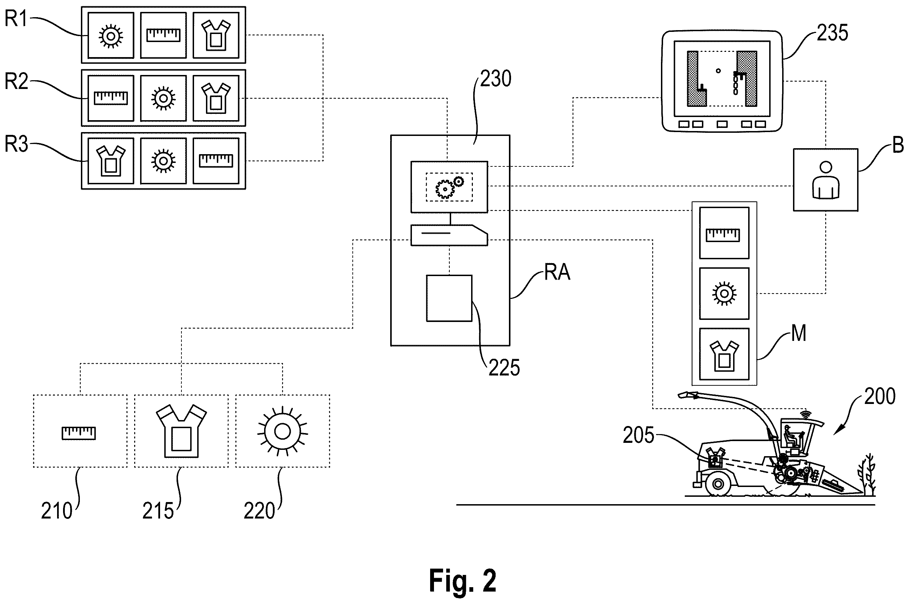

Fig. 2 zeigt eine schematische Darstellung eines Reparaturassistenten RA mit einem System zur Datenverarbeitung 230 für Reparaturen einer landwirtschaftlichen Arbeitsmaschine 200 gemäß einer Ausführungsform.

Bei der landwirtschaftlichen Arbeitsmaschine 200 handelt es sich in diesem Beispiel um einen Feldhäcksler, der für die Ernte von Nutzpflanzen vorgesehen ist. Die landwirtschaftliche Arbeitsmaschine 200 weist das zu wartende Bauteil 205 auf, das in diesem Beispiel eine Motorkomponente ist.

Das System zur Datenverarbeitung 230 für Reparaturen umfasst einen Prozessor 225, der so angepasst und/oder konfiguriert ist, dass er das Verfahren 100 nach einem der vorherigen Aspekte ausführt. Der Reparaturassistent RA umfasst ferner eine Eingabevorrichtung 235 für eine Bedienereingabe zur Beschreibung der Mängel der landwirtschaftlichen Arbeitsmaschine 200 oder des zu wartenden Bauteils 205. Die Bedienereingabe erfolgt üblicherweise durch einen Bediener B, der ein Techniker oder ein Fahrer der landwirtschaftlichen Arbeitsmaschine 200 sein kann. Der Istzustand des zu wartenden Bauteils 205 wird hierbei erfasst, indem der Bediener B eine geführte Diagnose 110 mittels der Eingabevorrichtung 235 durchführt. Dafür kann der Bediener B beispielsweise ein Bild des zu wartenden Bauteils 205 erfassen. Es kann dabei möglicherweise ein Bildverarbeitungsalgorithmus (bspw. Segmentierung) zum Einsatz kommen, um den Istzustand basierend auf dem Bild zu ermitteln, wobei möglicherweise Schäden wie Risse oder Abnutzungen detektiert werden können.

Das computergestützte Modell kann auf einem Speichermedium des Reparaturassistenten RA bereitgestellt werden. Nachdem der Istzustand des zu wartenden Bauteils 205 erfasst wurde, kann der Reparaturassistent RA das computergestützte Modell an den Istzustand des zu wartenden Bauteils 205 anpassen. Abschließend können die Reparaturmaßnahmen zum Reparieren der landwirtschaftlichen Arbeitsmaschine 200 bzw. des zu wartenden Bauteils 205 ermittelt werden.

Dafür kann der Reparaturassistent RA bzw. System zur Datenverarbeitung 230 derart eingerichtet sein, weitere Schritte des zuvor beschriebene Verfahrens 100 auszuführen, wobei das Verfahren 100 eine computergestützte Simulation umfassen kann. Es können dabei beispielsweise ein oder mehrere simulierte Reparaturszenarien R1, R2 und R3 der landwirtschaftlichen Arbeitsmaschine 200 bestimmt werden, indem beispielsweise verschiedene Maßnahmen mittels der computergestützten Modelle simuliert werden. Mit anderen Worten kann die Simulation dabei unterstützen, ein passendes Reparaturszenarium R1, R2 oder R3 auszuwählen und basierend auf dem passenden Reparaturszenarium R1, R2 oder R3 eine Reparaturmaßnahme abzuleiten, die eine besonders effiziente Instandsetzung der landwirtschaftlichen Arbeitsmaschine 200 gewährleistet.

Eine Vielzahl von Reparaturschritten 210, 215 und 220 kann im Reparaturassistenten RA gespeichert vorliegen bzw. in einer Datenbank hinterlegt sein. Ein Reparaturszenarium R1, R2 oder R3 kann dabei einen oder mehrere Reparaturschritte 210, 215 oder 220 umfassen. Ein erster Reparaturschritt 210 kann beispielsweise ein Kalibrieren der Motorsteuerung sein. Ein zweiter Reparaturschritt 215 kann beispielsweise ein Austausch einer Motorkomponente sein. Ein dritter Reparaturschritt 220 kann beispielsweise eine Montage oder eine Fixierung einer Motorkomponente sein.

Die Reparaturszenarien R1, R2 und R3 werden mittels des computergestützten Modells bestimmt, indem eine Vielzahl von Reparaturschritten 210, 215 und 220 festgelegt wird, verschiedene Reihenfolgen für die Reparaturschritte 210, 215 und 220 ermittelt werden und jedem Reparaturszenarium R1, R2 und R3 eine Reihenfolge der Reparaturschritte 210, 215 und 220 zugeordnet wird. Beispielsweise sieht ein erstes Reparaturszenarium R1 vor, dass als erstes ein Kalibrieren der Motorsteuerung (Reparaturschritt 220), daraufhin ein Austausch einer Motorkomponente (Reparaturschritt 210) und schließlich eine Montage oder eine Fixierung einer Motorkomponente (Reparaturschritt 215) erfolgt. Analog dazu können die weiteren Reparaturszenarien R2 und R3 andere Reihenfolgen für die Reparaturschritte 210, 215 und 220 vorsehen.

Das Simulieren kann ferner in einem Schritt ein Erstellen eines virtuellen Szenariums im computergestützten Modell umfassen, wobei das virtuelle Szenarium die aktuelle Konfiguration der landwirtschaftlichen Arbeitsmaschine 200 widerspiegelt. Die aktuelle Konfiguration der landwirtschaftlichen Arbeitsmaschine kann beispielsweise die spezifische Ausstattung (bspw. die Art des Vorsatzgeräts) umfassen. Das virtuelle Szenarium kann ferner die Umgebung (bspw. Werkstatt) und/oder die auf die landwirtschaftliche Arbeitsmaschine 200 äußeren Einflüsse abbilden. Das computergestützte Modell kann dabei ein dreidimensionales Modell des zu wartenden Bauteils 205 umfassen, das eine geometrische Struktur und/oder Materialeigenschaften abbildet, wobei die geometrische Struktur optional von dem erfassten Istzustand des zu wartenden Bauteils 205 abgeleitet wird.

In einem weiteren Schritt kann das Simulieren ein Ermitteln von Simulationsergebnissen umfassen, indem eine Reparaturmaßnahme R1, R2 oder R3 implementiert wird und Belastungs- und Funktionsanalysen, bspw. basierend auf einer Finite-Elemente-Methode, innerhalb des virtuellen Szenariums durchgeführt werden.

Das Simulieren kann ferner in einem Schritt ein Generieren eines Berichts über die Simulationsergebnisse umfassen, der detaillierte Informationen zu den durchgeführten Analysen, den erwarteten Leistungsverbesserungen und potenziellen Risiken der Reparaturmaßnahmen enthält.

Mittels der Reparaturszenarien R1, R2 oder R3 kann eine Reparaturmaßnahme M ermittelt werden, die beispielsweise an den Bediener B übermittelt wird bzw. diesem angezeigt wird. Im vorliegenden Fall wurde die Reparaturmaßnahme M beispielsweise von dem Reparaturszenarium R2 abgeleitet. Dies kann bedeuten, dass als Reparaturmaßnahme M die in Reparaturszenarium R2 vorgesehenen Reparaturschritte an der landwirtschaftlichen Arbeitsmaschine 200 automatisiert oder manuell angewendet werden sollen. Es ist ferner möglich, dass der Reparaturassistent RA die Reparaturmaßnahme M an der landwirtschaftlichen Arbeitsmaschine 200 veranlasst. Dafür kann der Reparaturassistent RA zusätzliche Vorrichtungen, wie etwa einen mechanischen Greifarm, aufweisen, die die Reparaturmaßnahmen M, wie beispielsweise Montage, Demontage oder Reinigung, ausführen.

### Bezugszeichenliste

- 100: Computer-implementiertes Verfahren
- 110: geführte Diagnose
- 200: landwirtschaftliche Arbeitsmaschine
- 205: zu wartendes Bauteil
- 210: erster Reparaturschritt
- 215: zweiter Reparaturschritt
- 220: dritter Reparaturschritt
- 225: Prozessor
- 230: System zur Datenverarbeitung
- 235: Eingabevorrichtung

- RA: Reparaturassistent
- R1: erstes Reparaturszenarium
- R2: zweites Reparaturszenarium
- R3: drittes Reparaturszenarium
- M: Reparaturmaßnahme
- B: Bediener

- S1.1: Bereitstellen eines computergestützten Modells
- S1.2: Erfassen eines Istzustands des zu wartenden Bauteils
- S1.2a: Erfassen einer Bedienereingabe zur Beschreibung der Mängel der landwirtschaftlichen Arbeitsmaschine oder des zu wartenden Bauteils
- S1.2b: Navigieren durch einen interaktiven Entscheidungsbaum basierend auf den Bedienereingaben und dem dem zu wartenden Bauteil zugeordneten computergestützten Modell
- S1.2c: Erfassen des Istzustands des zu wartenden Bauteils
- S1.3: Anpassen des computergestützten Modells an den erfassten Istzustand des zu wartenden Bauteils
- S1.4: Bestimmen von Reparaturszenarien der landwirtschaftlichen Arbeitsmaschine basierend auf dem computergestützten Modell
- S1.5: Ermitteln einer Reparaturmaßnahme mittels der Reparaturszenarien
- S1.6: Veranlassen der Reparaturmaßnahme an der landwirtschaftlichen Arbeitsmaschine

## Patentansprüche

1. Computer-implementiertes Verfahren (100) zum Reparieren einer landwirtschaftlichen Arbeitsmaschine (200), wobei die landwirtschaftliche Arbeitsmaschine (200) ein zu wartendes Bauteil (205) umfasst,
das Verfahren (100) umfassend:
Bereitstellen (S1.1) eines computergestützten Modells, wobei das computergestützte Modell dem zu wartenden Bauteil (205) zugeordnet ist;
Erfassen (S1.2) eines Istzustands des zu wartenden Bauteils (205) und anpassen (S1.3) des computergestützten Modells an den erfassten Istzustand des zu wartenden Bauteils (205);
Bestimmen (S1.4) von Reparaturszenarien (R1, R2, R3) der landwirtschaftlichen Arbeitsmaschine (200) basierend auf dem computergestützten Modell; und
Ermitteln (S1.5) einer Reparaturmaßnahme (M) mittels der Reparaturszenarien (R1, R2, R3).

2. Verfahren (100) nach Anspruch 1,
das Verfahren (100) umfassend:
Erfassen eines Istzustands des zu wartenden Bauteils (205), indem eine geführte Diagnose (110) durchgeführt wird,
die geführte Diagnose (110) umfassend:
Erfassen (1.2a) einer Bedienereingabe zur Beschreibung der Mängel der landwirtschaftlichen Arbeitsmaschine oder des zu wartenden Bauteils (205);
Navigieren (1.2b) durch einen interaktiven Entscheidungsbaum basierend auf den Bedienereingaben und dem dem zu wartenden Bauteil (205) zugeordneten computergestützten Modell, wobei optional spezifische Tests oder Inspektionen zur weiteren Fehlerdiagnose vorgeschlagen werden; und
Erfassen (1.2c) des Istzustands des zu wartenden Bauteils (205), indem die Testergebnisse zusammengefasst werden.

3. Verfahren (100) nach Anspruch 1 oder 2,
das Verfahren (100) umfassend:
Bestimmen eines simulierten Reparaturszenariums der landwirtschaftlichen Arbeitsmaschine (200), indem verschiedene Maßnahmen mittels der computergestützten Modelle simuliert werden,
wobei das Simulieren umfasst:
Erstellen eines virtuellen Szenariums im computergestützten Modell, wobei das virtuelle Szenarium die aktuelle Konfiguration der landwirtschaftlichen Arbeitsmaschine (200) widerspiegelt;
Ermitteln von Simulationsergebnissen, indem ein Reparaturmaßszenarium (R1, R2, R3) implementiert wird und Belastungs- und Funktionsanalysen innerhalb des virtuellen Szenariums durchgeführt werden; und
Generieren eines Berichts über die Simulationsergebnisse, der detaillierte Informationen zu den durchgeführten Analysen, den erwarteten Leistungsverbesserungen und potenziellen Risiken des Reparaturszenariums (R1, R2, R3) enthält.

4. Verfahren (100) nach einem der vorhergehenden Ansprüche,
Veranlassen (S1.6) der Reparaturmaßnahme (M) an der landwirtschaftlichen Arbeitsmaschine (200), wobei die Reparaturmaßnahme (M) insbesondere den Austausch des zu wartenden Bauteils (205) gegen ein baugleiches Neuteil, ein bauähnliches Bauteil, ein generalüberholtes Bauteil oder ein aktualisiertes Bauteil umfasst.

5. Verfahren (100) nach einem der vorhergehenden Ansprüche, wobei die Reparaturszenarien (R1, R2, R3) mittels des computergestützten Modells bestimmt werden, indem eine Vielzahl von Reparaturschritten (210, 215, 220) festgelegt wird, verschiedene Reihenfolgen für die Reparaturschritte (210, 215, 220) ermittelt werden und jedem Reparaturszenarium (R1, R2, R3) eine Reihenfolge der Reparaturschritte (210, 215, 220) zugeordnet wird.

6. Verfahren (100) nach einem der vorhergehenden Ansprüche, wobei die Ermittlung der Reparaturmaßnahme durch eine Priorisierung der Reparaturszenarien (R1, R2, R3) erfolgt, wobei die Priorisierung auf der Grundlage der Kosten, der Zeit und/oder dem Energieaufwand ermittelt wird.

7. Verfahren (100) nach einem der vorhergehenden Ansprüche, wobei das computergestützte Modell ein dreidimensionales Modell des zu wartenden Bauteils (205) umfasst, das eine geometrische Struktur und/oder Materialeigenschaften abbildet, wobei die geometrische Struktur optional von dem erfassten Istzustand des zu wartenden Bauteils (205) abgeleitet wird.

8. Verfahren (100) nach einem der vorhergehenden Ansprüche, wobei das Bereitstellen des computergestützten Modells umfasst:
Bereitstellen eines allgemeinen Modells für das zu wartende Bauteil (205);
Erfassen von Informationen über das zu wartende Bauteil (205), wobei die Informationen optional historische Daten früherer Wartungen und Reparaturen des zu wartenden Bauteils (205) umfassen; und
Anpassen des allgemeinen Modells basierend auf Informationen über das zu wartende Bauteil (205), so dass das computergestützte Modell abgeleitet wird.

9. Verfahren (100) nach einem der vorhergehenden Ansprüche, wobei das Ermitteln der Reparaturmaßnahme (M) umfasst:
Analyse der Reparaturszenarien (R1, R2, R3), indem verschiedene Reparaturszenarien (R1, R2, R3) basierend auf dem Istzustand des zu wartenden Bauteils (205) und/oder den verfügbaren Ressourcen identifiziert und bewertet werden;
Auswählen eines optimalen Reparaturszenariums (R1, R2, R3), indem Kosten, Zeit und Energieaufwand der Maßnahmen gegeneinander abgewogen werden; und
Ermitteln von Reparaturmaßnahmen (R1, R2, R3) aus dem optimalen Reparaturszenarium (R1, R2, R3), indem Reparaturschritte (210, 215, 220) aus dem optimalen Reparaturszenarium (R1, R2, R3) abgeleitet werden.

10. Verfahren zur Durchführung einer geführten Reparatur eines zu wartenden Bauteils (205) basierend auf einer ermittelten Reparaturmaßnahme (M) nach einem der vorhergehenden Ansprüche, umfassend:
Bereitstellen einer detaillierten Anleitung zur Reparaturmaßnahme (M), die spezifische Schritte und erforderliche Werkzeuge beschreibt;
Bereitstellen eines landwirtschaftlichen Reparaturassistenten, der den Bediener in Echtzeit durch den Reparaturprozess führt, indem er visuelle und akustische Hinweise gibt; und
Überwachen des Reparaturfortschritts mittels Sensoren und/oder Feedback-Systemen.

11. System zur Datenverarbeitung (230) für Reparaturen einer landwirtschaftlichen Arbeitsmaschine (200), umfassend einen Prozessor (225), der so angepasst und/oder konfiguriert ist, dass er das Verfahren (100) nach einem der vorherigen Ansprüche ausführt.

12. Landwirtschaftlicher Reparaturassistent (RA) mit einem System zur Datenverarbeitung (230) nach Anspruch 11.
